# EUROPEAN PATENT SPECIFICATION

(11) **EP 0 269 061 B1**
(45) Date of publication and mention of the grant of the patent: **18.08.1993**
(21) Application number: 87117295.3
(22) Date of filing: 24.11.1987
(51) Int. Cl.: G02B 6/12, G02F 1/015, G02B 5/20, H01S 3/06

(54) **An optical filter device**
Optische Filtervorrichtung
Dispositif à filtrage optique

(30) Priority: 26.11.1986 JP 279779/86
(43) Date of publication of application: 01.06.1988
(73) Proprietor: NEC CORPORATION, Tokyo (JP)
(72) Inventor: Numai, Takahiro c/o NEC Corporation, Minato-ku Tokyo (JP)
(74) Representative: VOSSIUS & PARTNER

(56) References cited:
- EP-A- 0 125 608
- EP-A- 0 173 269
- NEUES AUS DER TECHNIK, no. 6, 15th December 1981, page 2, item 645, Würzburg ; "Optischer Verstärker mit niedriger Superlumineszenz".
- APPLIED PHYSICS LETTERS, vol. 49, no. 3, 21st July 1986, pages 125-127, Woodbury, New York, US ; R.C. ALFERNESS et al. : "Narrowband grating resonator filters in InGaAsP/InP waveguides"
- APPLIED PHYSICS LETTERS, vol. 45, no. 12, December 1984, pages 1279-1280, Woodbury, New York, US ; R.C. ALFERNESS et al. : "InGaAsP/InP waveguide grating filters for gamma=1, 5nm".

## Description

The invention relates to an optical filter device, and more particularly to an optical filter device in which a predetermined wavelength of an optical signal is selected from wavelength division multiplexed optical signals.

One of conventional optical filter devices includes an optical distributed feedback structure provided in an optical amplifying device which utilizes a semiconductor active layer. In the optical filter device, a variable tuning of a predetermined wavelength which is selected from wavelength division multiplexed optical signals can be performed by changing the density of a carrier injected into the active layer. Further, the optical filter device is of a transmission type which is well adapted to a higher integration. For these reasons, the optical filter device is expected to be applied to a wide practical use. Especially, a distributed feedback structure having a diffraction grating is more advantageous in regard to properties of the wavelength selection and integration for the optical feedback structure than a Fabry Perot resonator having cleaved facets. Such an optical filter device as using the distributed feedback structure has been proposed on pages 123 to 126 of "Optics Communications", volume 10, number 2, February 1974, and theoretical studies thereof have been made therein.

Another conventional optical filter device has been studied on pages 125 to 127 of "Appl. Phys. Lett." 49(3), 21 July 1986. The kind of an optical filter device which has no gain includes an optical guide layer provided on a substrate, and a λ/4 shifted diffraction grating in which phases are deviated in the vicinity of the center position by λ/4, where λ is a wavelength to be propagated therein. The characteristic of the optical filter device is that a sharp transmitting bandwidth of less than 1 to 2Å is obtained in the vicinity of Bragg wavelength.

Such an optical filter device as a former and latter optical filter devices described above has the function to select a predetermined wavelength of an optical signal from wavelength division multiplexed optical signals, so that the optical filter device plays an important role in such a wide use as in optical communication systems, optical switching apparatusses, and optical signal processing etc. Accordingly, it is strongly desired that a satisfactory wavelength selection and a wide variable tuning range of wavelength selection are obtained in the optical filter device. Further, it is indispensable that the optical filter device is of a structure of an optical integrated circuit. Therefore the optical filter device is required to be of a transmission type in which only a predetermined wavelength of an optical signal is transmitted therethrough.

According to the former and latter optical filter devices, however, there are resulted following disadvantages.

In the former optical filter device including a distributed feedback structure in an optical amplifying device, the optical gain for a selection wavelength and the intensity of a natural radiation light are inevitably changed simultaneously with the density change of carriers which are injected into the active layer for the tuning of a selection wavelength. As a result, the density of the carriers injected into the active layer is limited to be small in its tuning range when a satisfactory selection of a wavelength and a predetermined ratio of an optical signal in regard to noise signals are to be obtained. For this reason, a variable tuning range of a selection wavelength is as small as several Å so that the optical filter device is only applied to an optical system having several channels.

In the latter optical filter device having no gain, transmitting wavelengths are fixed due to its own property. In this respect, a transmitting wavelength can be shifted in the direction of a shorter wavelength in a case where electrodes are provided between the back surface of a substrate and upper surface of a crystal growth layer formed on the diffraction grating to inject electric current thereinto so that a plasma effect is induced therein to result in the shift of a selection wavelength. On the contrary, the intensity of an optical signal is decreased due to the increase of an absorption loss when electric current is injected as described above.

EP-A-0 173 269 describes a semiconductor laser device with an active and a tuning region. Appl. Phys. Lett. 49, 125 (1986) describes a passive device, namely a narrow band grating resonator filter having a grating with two portions being phase shifted by π/2 with respect to each other.

Accordignly, it is an object of the invention to provide an optical filter device in which a large tuning range of a wavelength and optical gain for a transmission wavelength are obtained.

It is a further object of the invention to provide an optical filter device in which a predetermined wavelength of an optical signal is selected from wavelength division multiplexed optical signals of as much as 60 channels.

It is a still further object of the invention to provide an optical filter device in which a decrease of a ratio of an optical signal in regard to noise signals by the natural radiation light is prevented.

These objects are solved with the features of claim 1.

The invention will be described in more detail in conjunction with following drawings wherein,
Fig. 1 is a partially cut perspective view showing an optical filter device in an embodiment according to the invention,
Figs. 2A to 2C are cross sectional views respectively cut along the lines 2A - 2A to 2C - 2C in Fig. 1, and
Figs. 3A and 3B are explanatory diagrams showing a wavelength shift by changing an injection current in the embodiment according to the invention.

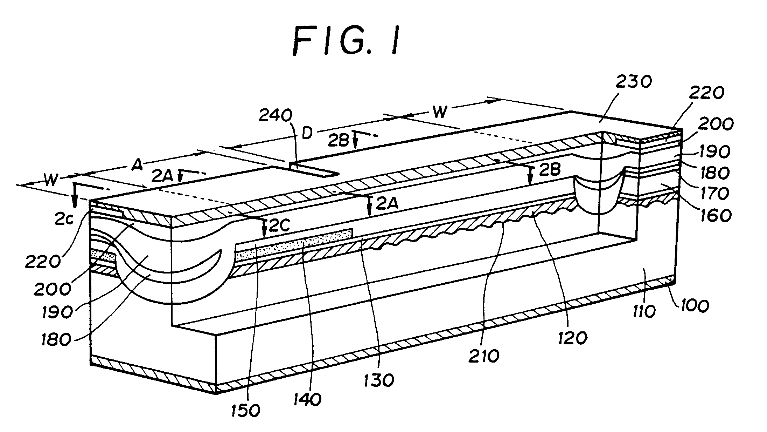

In Fig. 1, there is shown an optical filter device in an embodiment according to the invention. The optical filter device comprises a substrate 110 of InP, an optical guide layer 120 of non-doped InGaAs, a buffer layer 130 of n-InP, a non-doped active layer 140, a cladding layer 150 of p-InP, a cladding layer 160 of p-InP, a p-InP layer 170, an n-InP layer 180, a p-InP layer 190, an InGaAsP layer 200, an oxidation film layer 220 of SiO₂, and electrodes 100 and 230, respectively provided on the upper surface of the oxidation film layer 220 and the back surface of the substrate 110.

In the optical filter device, a distributed feedback region D, an active region A, window regions W are defined respectively wherein a groove 240 is formed except a region in the vicinity of a center mesa between the distribution feedback region D and active region A. In the distributed feedback region D, a λ/4 shifted diffraction grating having a λ/4 shift position 210 and a period of, for instance, 2400Å is formed on the substrate 110 wherein phases are deviated in the center position 210 by λ/4, where λ is a wavelength propagated therein. Therefore, a concave and convex shapes are reversed on the both sides of the shift position 210 in a primary diffraction grating because a period thereof is λ/2.

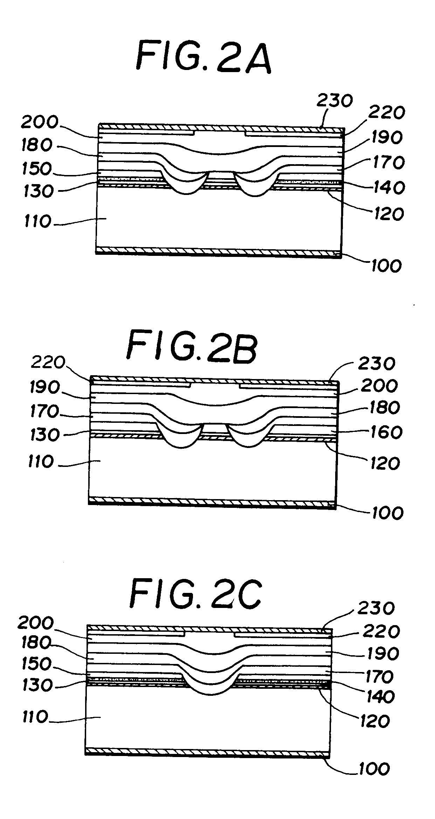

In Fig. 2A, the cross section of the active region A is shown to be cut along the line 2A - 2A in Fig. 1 wherein like parts are indicated by like reference numerals. Further, the cross sections of the distributed feedback region D and window region W are shown in Figs. 2B and 2C to be cut along the lines 2B - 2B and 2C - 2C in Fig. 1, respectively wherein like parts are also indicated by like reference numerals.

The optical filter device described above is fabricated as follows.

At first, the λ/4 shifted diffraction grating having the shift position 210 is provided on a region corresponding to the distributed feedback region D of the InP substrate 110. Next, the non-doped InGaAs optical guide layer 120 having a thickness of 0.3µm and λg of 1.3µm, the n-InP buffer layer 130 having a thickness of 0.1µm, the non-doped active layer 140 having a thickness of 0.1µm and λg of 1.53µm, and the p-InP cladding layer 150 having a thickness of 0.2µm are sequentially formed by a first process of liquid phase epitaxial growth. Thereafter, the active layer 140 and InP cladding layer 150 are selectively removed in portions corresponding to the distributed feedback and window regions D and W. Then, the p-InP cladding layer 160 is formed on the overall area by a second process of liquid phase epitaxial growth. After an etching process is performed to prepare the formation of a structure in which a semiconductor material having a refractive index lower than those of the optical guide layer and the active layer is buried in the vicinity of the facets, i.e. a window structure; the buried structure is provided to form the window regions W by a third process of liquid phase epitaxial growth wherein the buried heterostructure is of a double channel planar buried heterostructure. Finally, the electrodes 100 and 230 are provided on the upper surface of the growth layers and back surface of the substrate 110, respectively, and the groove 240 is provided to be of 20µm in its width except a region in the vicinity of a center mesa between the active region A and distributed feedback region D. The window regions W, active region A, and distributed feedback region D are of 30µm, 100µm,and 500 µm in their length, respectively.

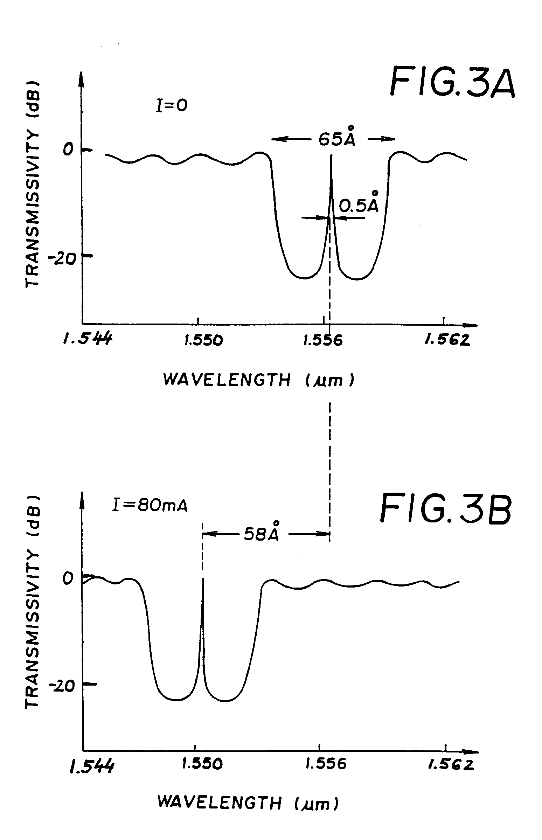

The transmission property of the optical filter device thus fabricated is explained in Figs. 3A and 3B.

The extinction ratio of more than 20dB is obtained, and a 10dB down bandwidth for a transmission wavelength is 0.5Å.

When no electric current is injected into the active region A and the distributed feedback region D (I=0 in Fig. 3A), the transmission wavelength is 1.5563µm. If, however, the injected electric current is 80mA (I=80mA in Fig. 3B), the transmission wavelength is 1.5505 µm. Further, the transmission wavelength is successively changed in a range of 58Å in accordance with the control of the injection current 0 to 80mA. Still further, the depth of the diffraction grating is 800Å, and the stopband is 65Å.

According to the transmission property of the optical filter device in the invention, it is understood that a predetermined wavelength of an optical signal can be selected from optical signals of 60 channels to be propagated by an interval of 0.5Å in a range of 30Å which is approximately half of the stopband.

Although the optical filter device in the embodiment according to the invention is explained, other semiconductor or dielectric materials may be used in place of the material as described above. Further, an optical waveguide structure may be of another type of a structure other than a planar structure or buried structure. In this respect, for instance, a surface type structure in which a light is transmitted vertically in regard to multiple-layers may be adopted. Still further, a surface type structure in which layers having different refractive indexes are provided alternately may be used in the distributed feedback structure in place of a structure in which a diffraction grating is provided on an optical waveguide. Otherwise, if an anti-reflection coating is provided on the both facets of the optical filter device, the coupling efficiency of the incident light supplied to the optical filter device is increased so that the characteristic thereof is much improved.

As clearly understood from the optical filter device in the embodiment according to the invention, the operation of an optical filter device according to the invention will be explained below.

In an optical transmission property of an optical waveguide having a distributed feedback structure in which no gain is obtained in a transmission wavelength band, a stopband is formed with a width of approximately several tens Å in the center of which Bragg wavelength to be defined by an optical period of a diffraction grating therein is located when optical phases are aligned in a distributed feedback region. In a case where the optical phases are deviated by π on the both sides in the center of the distributed feedback region, the stop wavelength band of approximately several tens Å is divided into two bands so that a narrow bandwidth of approximately one to two Å is provided between the two bands to transmit an optical signal in the center of the above mentioned stopband. In other words, the pitch of the diffraction grating is deviated by λ/4, where λ is a wavelength which is propagated in the optical filter device. Therefore, this is called "a λ/4 shifted structure". If an optical waveguide, which is provided with a distributed feedback region having the λ/4 shifted structure, is fabricated by a semiconductor of a composition which is on the side of a shorter wavelength than a transmission wavelength, there is produced no gain therein so that a wavelength selection can be performed in a narrow width of less than approximately 1 to 2Å and in a much wider band in the center of Bragg wavelength by injecting carriers thereinto, and the deterioration of the ratio of an optical signal in regard to noise signals due to a natural radiation light is prevented.

For the purpose of providing an optical filter device having an amplifying function, further, an active region and distributed region are coupled optically because the above mentioned optical waveguide layer has no gain. That is to say, an optical filter device having an amplifying function is obtained, if a construction is provided in which a light is supplied to the active region to be amplified therein, and then transmitted through the distributed feedback region. In this point, attention must be paid to the construction that the optical filter device must be of anti-reflection structure at the both facets. This is a reason why oscillation is occured in the optical filter device to result in a distributed feedback type laser, unless such an anti-reflection structure is provided therein. The anti-reflection structure is obtained by providing a window structure or by coating SiN film on both facets. In a practical use, the window structure is preferable to refrain a reflection from being occured thereon reliably.

## Claims

1. An optical filter device comprising
a substrate (110),
a layered structure formed on said substrate,
and electrodes (100, 230) positioned on the back surface of said substrate (110) and on the upper surface of said layered structure,
said layered structure comprising
an optical guide layer (120), a first portion of which is provided with a diffraction grating, said grating constituting a distributed feedback region (D),
and an active layer (140), which is positioned above a second portion of said optical guide layer, said active layer constituting an active region (A),
**characterized in that**
said active region and said distributed feedback region are arranged between antireflection structures which are optically coupled to said optical guide layer,
in that said electrode (230) on said upper surface is a single electrode, which covers said active region, said distributed feedback region and said antireflection structures,
and in that said diffraction grating comprises a λ/4 shift structure (210).

2. An optical filter device according to claim 1,
wherein each of said anti-reflection structures is a window structure (W).

3. An optical filter device according to claim 1 or 2 further comprising,
a groove (240) formed in said layered structure between said distributed feedback region (D) and said active region (A) except a portion of a mesa in the center thereof.

## Patentansprüche

1. Optische Filtervorrichtung mit
einem Substrat (110),
einer auf dem Substrat ausgebildeten Schichtstruktur und Elektroden (100, 230), die auf der Unterseite des Substrats (110) und auf der Oberseite der Schichtstruktur angeordnet sind,
wobei die Schichtstruktur aufweist:
eine optische Leiterschicht (120), einen ersten mit einem Beugungsgitter versehenen Abschnitt, wobei das Gitter einen verteilten Rückkopplungsbereich (D) und eine aktive Schicht (140) bildet, die über einem zweiten Abschnitt der optischen Leiterschicht angeordnet ist und wobei die aktive Schicht einen aktiven Bereich (A) bildet,
**dadurch gekennzeichnet, daß**
der aktive Bereich und der verteilte Rückkopplungsbereich zwischen reflexionshemmenden Strukturen angeordnet sind, die optisch mit der optischen Leiterschicht gekoppelt sind,
die Elektrode (230) auf der Oberseite eine Einzelelektrode ist, die den aktiven Bereich, den verteilten Rückkopplungsbereich und die reflexionshemmenden Strukturen erfaßt und
das Beugungsgitter eine λ/4-Verschiebungsstruktur (210) aufweist.

2. Optische Filtervorrichtung nach Anspruch 1,
wobei jede der reflexionshemmenden Strukturen eine Fensterstruktur (W) ist.

3. Optische Filtervorrichtung nach Anspruch 1 oder 2, ferner mit:
einer Nut (240), die in der Schichtstruktur zwischen dem verteilten Rückkopplungsbereich (D) und dem aktiven Bereich (A) mit Ausnahme eines Mesaabschnitts in dessen Mitte ausgebildet ist.

## Revendications

1. Dispositif de filtre optique comprenant :
un substrat (110),
une structure à couches formée sur le substrat,
et des électrodes (100, 230) positionnées sur la surface arrière du substrat (110) et sur la surface supérieure de la structure à couches,
la structure à couches comprenant :
une couche de guidage optique (120), dont une première partie est prévue avec un réseau de diffraction, le réseau de diffraction constituant une région de contre-réaction distribuée (D), et une couche active (140) qui est placée au-dessus d'une seconde partie de la couche de guidage optique, la couche active constituant une région active (A),
caractérisé en ce que
la région active et la région de contre-réaction distribuée sont disposées entre des structures anti-réflexion qui sont optiquement couplées à la couche de guidage optique, en ce que l'électrode (230) sur la surface supérieure est une seule électrode, qui recouvre la région active, la région de contre-réaction distribuée et les structures anti-réflexion,
et en ce que le réseau de diffraction comprend une structure à décalage de λ/4 (210).

2. Dispositif de filtre optique selon la revendication 1, dans lequel chacune des structures anti-réflexion est une structure à fenêtre (W).

3. Dispositif de filtre optique selon la revendication 1 ou 2, comprenant de plus,
une rainure (240) formée dans la structure à couches entre la région de contre-réaction distribuée (D) et la région active (A) sauf pour une partie de mesa située au centre de celle-ci.
